# DEMANDE DE BREVET EUROPEEN

(11) **EP 0 872 960 A1**
(43) Date de publication de la demande: **21.10.1998**
(21) Numéro de dépôt: 98201030.8
(22) Date de dépôt: 01.04.1998
(51) Int. Cl.: H03M 1/06, H04N 5/18

(54) **Dispositif d'alignement numérique.**

(30) Priorité: 15.04.1997 FR 9704597
(71) Demandeur: Koninklijke Philips Electronics N.V., 5621 BA Eindhoven (NL)
(72) Inventeur: Thies, William, 75008 Paris (FR); Vorenkamp, Pieter, 75008 Paris (FR)
(74) Mandataire: Caron, Jean

(57) **Abrégé**

Ce dispositif comporte un trajet principal de signal dans lequel une capacité est insérée en amont d'un convertisseur analogique-numérique dans lequel une conversion est déclenchée par une horloge.
Selon l'invention, la sortie du convertisseur analogique-numérique est reliée aux entrées de plusieurs détecteurs de seuil qui présentent des seuils de détection positifs en progression proportionnellement à des puissances de deux successives, et de plusieurs autres détecteurs de seuil qui présentent un seuil de détection négatif également en progression proportionnellement à des puissances de deux successives, et les détecteurs de seuil commandent des générateurs de courant dont les courants sont ajoutés dans la capacité.

Applications : systèmes de pré-traitement vidéo

## Description

La présente invention concerne un circuit intégré, comprenant entre autres un dispositif d'alignement qui comporte un trajet principal de signal dans lequel une capacité est insérée en amont d'un convertisseur analogique-numérique dans lequel une conversion est déclenchée par une horloge, ainsi que des détecteurs de seuil munis chacun d'une entrée et d'une sortie et de moyens pour délivrer en sortie un signal logique si la tension d'entrée franchit une valeur de seuil déterminée et différente pour chaque détecteur de seuil, et au moins deux générateurs de courant munis chacun d'une entrée de commande et d'une sortie de courant et de moyens pour fournir sur commande un courant calibré destiné à être introduit dans la capacité, la sortie du convertisseur analogique-numérique étant reliée ensemble aux entrées de tous les détecteurs de seuil.

L'invention s'applique notamment dans les systèmes de pré-traitement vidéo.

Un dispositif d'alignement selon le préambule ci-dessus est connu du document EP 0 714 169.

Un objet de l'invention est de fournir un dispositif d'alignement d'action rapide, utilisable dans de larges gammes d'amplitude du signal et de fréquence d'horloge.

A cet effet plusieurs détecteurs de seuil présentent un seuil de détection positif, dont les valeurs de tensions de seuil sont, d'un détecteur à l'autre, en progression proportionnellement à des puissances de deux successives, et plusieurs autres détecteurs de seuil présentent un seuil de détection négatif, dont les valeurs absolues des tensions de seuil sont aussi en progression proportionnellement à des puissances de deux successives, et à chaque détecteur de seuil correspond un générateur de courant, les sorties de tous les générateurs de courant étant branchées de façon à ajouter leurs courants les uns aux autres.

Ainsi, une meilleure convergence du processus d'ajustement du zéro est obtenue.

La sortie de chaque détecteur de seuil est reliée à l'entrée de signal d'une première bascule D dont la sortie est reliée à une première entrée d'une porte ET dont la sortie est reliée à l'entrée de commande de l'un des générateurs de courant, et la connexion d'horloge est reliée à l'entrée d'un diviseur par deux dont la sortie est reliée à la fois à l'entrée d'horloge de chacune des premières bascules D et à une seconde entrée de chacune des portes ET.

Ceci permet de réaliser alternativement une mesure, c'est-à-dire une conversion dans le convertisseur analogique/numérique, et un enregistrement d'un résultat de comparaison d'un comparateur dans la bascule D correspondante. Ainsi le circuit mesure et corrige alternativement, ce qui est préférable à une mesure et une correction simultanées, au cours desquelles le courant de correction d'erreur à travers une impédance d'entrée de 75Ω produirait une erreur importante de la tension à mesurer par le convertisseur.

Avantageusement, un interrupteur commandé par un signal de commande est inséré entre les générateurs de courant et la capacité, et le signal de commande de l'interrupteur est connecté en outre aux entrées de remise à zéro des premières bascules D.

Ceci permet de choisir les instants où la correction est appliquée.

Les générateurs de courant correspondant aux détecteurs successifs ayant les seuils absolus les plus élevés délivrent avantageusement des courants calibrés en progression, proportionnellement à des puissances de deux successives.

Ainsi, une convergence exponentielle du processus d'ajustement est obtenue.

Le dispositif comporte en outre avantageusement deux portes supplémentaires de type ET dont la sortie est reliée à l'entrée de commande de deux générateurs de courant supplémentaires dont les sorties sont branchées de façon à ajouter leurs courants à ceux des autres générateurs de courant, et deux détecteurs de signe munis chacun d'une entrée et d'une sortie et de moyens pour délivrer un signal logique en sortie selon le signe de la tension d'entrée, la sortie de chacun des détecteurs de signe étant reliée à l'entrée d'une des portes ET supplémentaires, les entrées de chacun des deux détecteurs de signe étant reliées ensemble à la sortie du convertisseur analogique-numérique, et le courant calibré délivré par les générateurs de courant supplémentaires est au moins plusieurs dizaines de fois inférieur à celui délivré par les autres générateurs de courant.

Ainsi les performances sont améliorées par la combinaison d'un réglage fin et d'un réglage grossier.

Dans une forme de réalisation particulière, le convertisseur analogique-numérique est d'un type à repliement.

Ainsi une information de passage par zéro est directement disponible en sortie du convertisseur analogique/numérique.

Le trajet principal comprend de préférence un amplificateur à gain réglable, placé entre la capacité et le convertisseur analogique-numérique, et des moyens sont alors avantageusement prévus pour ajuster le courant calibré délivré par les générateurs de courant en fonction du gain de l'amplificateur.

Ces aspects de l'invention ainsi que d'autres aspects plus détaillés apparaîtront plus clairement grâce à la description suivante d'un mode de réalisation constituant un exemple non limitatif.

La figure unique est un schéma d'un circuit intégré comprenant un dispositif d'alignement.

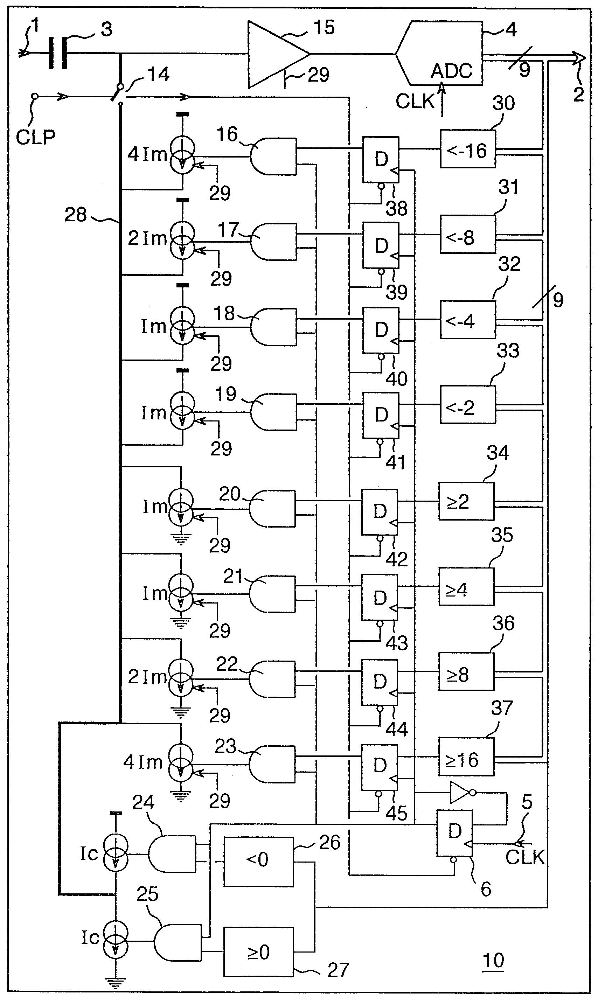

Le circuit intégré 10 représenté par la figure 1 comprend un dispositif d'alignement qui comporte, entre une entrée 1 et une sortie 2, un trajet principal de signal dans lequel une capacité 3 est insérée en amont d'un convertisseur analogique-numérique 4, dans lequel une conversion est déclenchée par une horloge CLK. La période de cette horloge est bien inférieure à la durée d'un palier d'alignement du signal ; pour une utilisation en télévision ou dans un moniteur d'ordinateur, elle peut avoir une fréquence à choisir entre 12 et 16 MHz, ou entre 16 et 40 MHz. Le convertisseur analogique-numérique délivre ici sur la sortie 2, possédant neuf conducteurs, une valeur convertie sur 9 bits, correspondant par exemple à des valeurs allant de zéro à 511. Le convertisseur analogique-numérique est d'un type à repliement : il donne, sur des conducteurs particuliers, le signe de la valeur ainsi qu'un signal pour les seuils inférieurs à -2, -4, - 8, -16. La présence de ces conducteurs particuliers permet l'utilisation du circuit pour un alignement au code zéro, ce qui n'aurait pas été possible avec un autre type de convertisseur.

Les entrées numériques de chacun de huit détecteurs de seuil 30-37 sont reliées ensemble à la sortie numérique du convertisseur analogique-numérique. Quatre de ces détecteurs de seuil (30 à 33) délivrent en sortie un signal logique si leur tension d'entrée numérique devient inférieure à une valeur de seuil déterminée et différente pour chaque détecteur de seuil, ces valeurs étant ici de respectivement -16, -8, -4, -2, en progression proportionnellement à des puissances de deux successives. Quatre autres détecteurs de seuil (34 à 37) délivrent en sortie un signal logique si leur tension d'entrée numérique devient supérieure ou égale à des valeurs de seuil valant respectivement +2, +4, +8, +16. En outre, ces seuils sont relatifs à des valeurs de code programmables 0, 32, 128, 256 : les valeurs des seuils indiqués sont donc relatifs, mesurés par rapport à la valeur programmée. Par exemple, un seuil de -2 par rapport à la valeur programmée 32 correspond ainsi à la valeur 30.

La sortie de chaque détecteur de seuil 30-37 est reliée respectivement à l'entrée de signal d'une bascule 38-45 de type D dont la sortie est reliée respectivement à une première entrée d'une porte 16-23 de type ET dont la sortie est reliée à chaque fois à l'entrée de commande d'un générateur de courant.

La connexion d'horloge 5 (CLK) est reliée à l'entrée d'un diviseur par deux, constitué d'une bascule 6 de type D rebouclée sur elle même avec inversion, dont la sortie est reliée à la fois à l'entrée d'horloge de chacune des premières bascules 38-45 et à une seconde entrée de chacune des portes 16-23, de façon à réaliser alternativement d'une part une conversion dans le convertisseur analogique/numérique, et d'autre part un enregistrement du résultat de la comparaison dans chaque bascule D.

A chaque détecteur de seuil 30-37 correspond un générateur de courant, muni d'une entrée de commande et d'une sortie de courant et de moyens pour fournir sur commande un courant calibré. Les sorties de tous les générateurs de courant sont branchées de façon à ajouter leurs courants les uns aux autres dans une connexion 28, en vue d'être introduits dans la capacité 3, va un interrupteur 14. Les courants calibrés des générateurs de courant qui sont commandés par les portes 16 à 19 ont des valeurs de respectivement 4Im, 2Im, Im, Im, et sont introduits à partir d'une alimentation positive dans la connexion 28. De même, les courants des générateurs de courant qui sont commandés par les portes 20 à 23 ont des valeurs respectivement Im, Im, 2Im, 4Im, mais ils sont tirés de la connexion 28 vers la masse.

L'interrupteur 14 est commandé par un signal de commande CLP qui est connecté à l'entrée de remise à zéro de chacune des premières bascules 38 à 45. Le signal CLP est actif pendant la durée où le signal d'entrée 1 correspond à un niveau d'étalonnage (niveau du noir en télévision).

Les deux générateurs de courant correspondant aux détecteurs 33 et 32 (ou 34 et 35) ayant en valeur absolue les plus petits seuils, délivrent des courants calibrés Im de même valeur, et les valeurs des courants calibrés 2Im, 4Im délivrés par les générateurs de courant correspondant aux détecteurs suivants 31 et 30 (ou 36 et 37) sont en progression, proportionnellement à des puissances de deux successives.

Deux portes supplémentaires 24 et 25 de type ET commandent deux générateurs de courant supplémentaires dont les sorties sont branchées de façon à ajouter leurs courants Ic à ceux des autres générateurs de courant dans la connexion 28. Deux détecteurs de signe 26 et 27 sont munis chacun d'une entrée et d'une sortie et de moyens pour délivrer un signal logique en sortie selon le signe de la tension d'entrée, et la sortie de chacun de ces détecteurs de signe est reliée à l'entrée d'une des portes 24, 25 supplémentaires, dont l'autre entrée est reliée à la sortie de la bascule 6 comme les autres portes. Les entrées de chacun des deux détecteurs de signe sont reliées ensemble à la sortie du convertisseur analogique-numérique 4. En utilisant pour le convertisseur analogique/numérique un modèle dit à repliement, on dispose, parmi les neuf conducteurs qui constituent sa sortie 2, d'un conducteur spécialisé indiquant le signe du signal. Ce conducteur est relié à l'entrée des détecteurs 26, 27.

Le courant calibré Ic délivré par les générateurs de courant supplémentaires est au moins plusieurs dizaines de fois inférieur à celui délivré par les autres générateurs de courant. Un exemple de valeurs pour les courants calibrés est de l'ordre du milliampère pour Im et de quelques micro-ampères pour Ic, ceci lorsque la source appliquée à l'entrée 1 a une impédance de 75Ω, la capacité 3 ayant une valeur de l'ordre de quelques dizaines de nano-farads.

Pour les détecteurs de seuil 33 et 34, dont le seuil est le plus bas, au lieu de la valeur deux comme indiqué, un seuil de trois pourrait être choisi, par exemple. De même le courant des générateurs de courant Ic peut être programmé dans une gamme de valeurs, par exemple entre 3 et 5µA. Un ajustage optimal de ces valeurs permet d'éviter des interférences entre l'action des générateurs de courant faible (Ic) d'une part, et celle des générateurs de courant fort (Im) d'autre part.

Le niveau de sortie peut être ajusté, en dehors de l'alignement du zéro, grâce à un amplificateur 15 placé dans le trajet principal entre la capacité 3 et le convertisseur analogique-numérique 4. Cet amplificateur est à gain réglable par un signal de commande appliqué à une entrée de commande de gain 29. Comme la grandeur de la dérive du zéro dépend du gain de l'amplificateur, la valeur des courants Im des générateurs de courant est ajustée en fonction du gain de l'amplificateur, par exemple au moyen du signal de commande 29. L'homme du métier sait réaliser un amplificateur à gain réglable, de même qu'un générateur de courant programmable, sans qu'une description détaillée soit ici nécessaire.

## Revendications

1. Circuit intégré, comprenant entre autres un dispositif d'alignement qui comporte un trajet principal de signal dans lequel une capacité est insérée en amont d'un convertisseur analogique-numérique dans lequel une conversion est déclenchée par une horloge, ainsi que des détecteurs de seuil munis chacun d'une entrée et d'une sortie et de moyens pour délivrer en sortie un signal logique si la tension d'entrée franchit une valeur de seuil déterminée et différente pour chaque détecteur de seuil, et au moins deux générateurs de courant munis chacun d'une entrée de commande et d'une sortie de courant et de moyens pour fournir sur commande un courant calibré destiné à être introduit dans la capacité, la sortie du convertisseur analogique-numérique étant reliée ensemble aux entrées des détecteurs de seuil, caractérisé en ce que plusieurs détecteurs de seuil présentent un seuil de détection positif, dont les valeurs de tensions de seuil sont, d'un détecteur à l'autre, en progression proportionnellement à des puissances de deux successives, et plusieurs autres détecteurs de seuil présentent un seuil de détection négatif, dont les valeurs absolues des tensions de seuil sont aussi en progression proportionnellement à des puissances de deux successives, et à chaque détecteur de seuil correspond un générateur de courant, les sorties de tous les générateurs de courant étant branchées de façon à ajouter leurs courants les uns aux autres.

2. Circuit intégré selon la revendication 1, caractérisé en ce que la sortie de chaque détecteur de seuil est reliée à l'entrée de signal d'une première bascule D dont la sortie est reliée à une première entrée d'une porte ET dont la sortie est reliée à l'entrée de commande de l'un des générateurs de courant, et la connexion d'horloge est reliée à l'entrée d'un diviseur par deux dont la sortie est reliée à la fois à l'entrée d'horloge de chacune des premières bascules D et à une seconde entrée de chacune des portes ET.

3. Circuit intégré selon la revendication 2, caractérisé en ce que un interrupteur commandé par un signal de commande est inséré entre les générateurs de courant et la capacité, et le signal de commande de l'interrupteur est connecté en outre aux entrées de remise à zéro des premières bascules D.

4. Circuit intégré selon la revendication 1, caractérisé en ce que les générateurs de courant correspondant aux détecteurs successifs ayant les seuils absolus les plus élevés délivrent des courants calibrés en progression, proportionnellement à des puissances de deux successives.

5. Circuit intégré selon la revendication 1, caractérisé en ce que le dispositif comporte en outre deux portes supplémentaires de type ET dont la sortie est reliée à l'entrée de commande de deux générateurs de courant supplémentaires dont les sorties sont branchées de façon à ajouter leurs courants à ceux des autres générateurs de courant, et deux détecteurs de signe munis chacun d'une entrée et d'une sortie et de moyens pour délivrer un signal logique en sortie selon le signe de la tension d'entrée, la sortie de chacun des détecteurs de signe étant reliée à l'entrée d'une des portes ET supplémentaires, et les entrées de chacun des deux détecteurs de signe étant reliées ensemble à la sortie du convertisseur analogique-numérique, et le courant calibré délivré par les générateurs de courant supplémentaires est au moins plusieurs dizaines de fois inférieur à celui délivré par les autres générateurs de courant.

6. Circuit intégré selon la revendication 5, caractérisé en ce que les détecteurs de seuil dont le seuil est le plus bas ont un seuil programmable.

7. Circuit intégré selon la revendication 5, caractérisé en ce que le convertisseur analogique-numérique est d'un type à repliement.

8. Circuit intégré selon la revendication 1, caractérisé en ce que le trajet principal comprend en outre un amplificateur à gain réglable, placé entre la capacité et le convertisseur analogique-numérique.

9. Circuit intégré selon la revendication 8, caractérisé en ce que il comprend des moyens pour ajuster le courant calibré délivré par les générateurs de courant en fonction du gain de l'amplificateur.
